Europäisches Patentamt

European Patent Office

Office européen des brevets

(19)

(11) Publication number: **0 130 669**
**A1**

(12) # EUROPEAN PATENT APPLICATION

(21) Application number: **84302855.6**

(22) Date of filing: **27.04.84**

(51) Int. Cl.⁴: **H 01 L 29/08, H 01 L 29/743**

(30) Priority: **30.04.83 JP 76406/83**
**30.04.83 JP 76450/83**

(43) Date of publication of application: **09.01.85**
**Bulletin 85/2**

(84) Designated Contracting States: **DE FR GB**

(71) Applicant: **Kabushiki Kaisha Toshiba, 72, Horikawa-cho Saiwai-ku, Kawasaki-shi Kanagawa-ken 210 (JP)**

(72) Inventor: **Kato, Minoru c/o Patent Division, Toshiba Corp. Princ. Office 1-1, Shibaura 1-chome, Minato-ku Tokyo 105 (JP)**

(74) Representative: **Shindler, Nigel et al, BATCHELLOR, KIRK & EYLES 2 Pear Tree Court Farringdon Road, London EC1R 0DS (GB)**

(54) Gate turn off thyristor with mesh cathode structure.

(57) A gate turn-off thyristor comprising a substrate with an anode layer (22) on one surface and a gate layer (23) on the opposite surface, and a cathode region (24) formed on said gate layer in a mesh-like pattern so as to leave portions of the gate layer selectively exposed as discrete islands (23a). This structure enables charge carriers to be more efficiently removed from the gate when a turn-off signal is applied to it.

**EP 0 130 669 A1**

## GATE TURN OFF THYRISTOR WITH MESH CATHODE STRUCTURE

This invention relates to a Gate Turn Off thyristor (GTO) and more particularly to a GTO having an improved turn-off characteristic operable at a high frequency.

If the anode current of a conventional GTO is increased, it is more difficult to turn off quickly when a turn-off signal is applied to the gate. Turn-off failure of the GTO will often then occur. One cause of such failure of the GTO is that charge carriers remain in the gate layer under the center portions of the cathode regions causing the GTO to remain in the ON state.

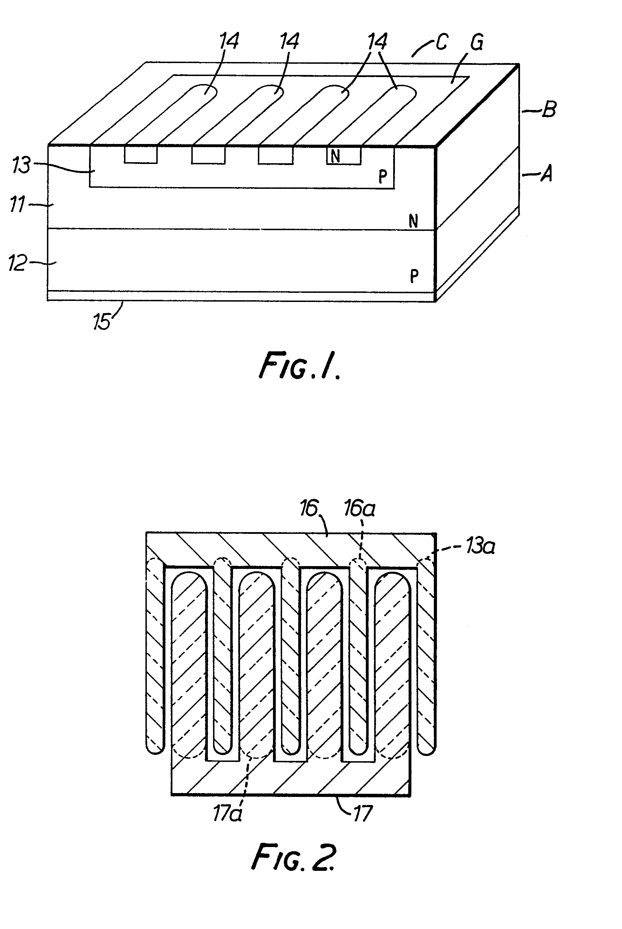

Therefore to control large anode currents for a given turn-off gate signal, a GTO having the structure shown in Fig. 1 and Fig. 2 was developed.

In Fig. 1, a base layer 11 is formed in a semiconductor substrate of N-conductivity type. An anode layer 12 and a gate layer 13 are formed by diffusing a P-type impurity into the semiconductor substrate on opposite major surfaces of said substrate. Substantially parallel, finger-like cathode strip regions 14 having an N-conductivity type are formed in the gate layer 13 equidistant from one another in the lateral direction. An anode electrode 15 is formed on a back surface of the anode layer 12. A cathode electrode and a gate electrode (not shown) are connected to the cathode strip regions 14 and the gate layer 13 respectively.

The pattern of the cathode and gate electrodes which is used with GTO of Fig. 1 is shown in Figure 2. The gate electrode 16 is in contact with the gate layer 13 at contact holes 16a, and the cathode electrode 17 is in contact with the cathode strip regions 14 at contact holes 17a. The gate electrode 16 and the cathode electrode 17 are comb-shaped and are interdigitated.

Using the structure shown in Fig. 1 and Fig. 2, a charge in the cathode strip regions 14 is discharged through the gate layer 13 surrounding the cathode strip regions 14 to the gate electrode 16 when the GTO is turned off. This structure acts to decrease the charge which is retained near the center of the cathode strip regions 14.

In order to reduce the turn off time of the GTO shown in Fig. 1, the width of the cathode strip regions 14 is decreased as much as possible; however, the possible decrease in width is limited by the photo engraving process used for manufacturing the GTO. The cathode strip regions 14 also form paths for the anode current during the ON state, so the decrease in area is also limited by the necessity to control the anode current. If the turn off gate signal is applied to the gate layer 13, the charge discharges from the center of the cathode strip regions 14. The narrower the cathode strip regions 14, the more the balance of charge distribution is affected in the longitudinal direction of the cathode strip regions 14. For that reason local current concentration occurs owing to the unbalanced charge distribution. The GTO then fails because of the local current concentration.

Thus, for example, such a GTO could not be used in

- 3 -    0130669

a power source circuit of 63 KHz (Reference frequency 15.75 KHz x 4) for television.

However, in a divided structure such as the cathode strip regions 14, if the number of cathode strip regions 14 is increased in order to be used at a high frequency, the ratio of cathode area to gate electrode area becomes too low. The size of the GTO then becomes large. Thus the conventional GTO has many defects.

Accordingly, the present invention seeks to provide a GTO which is small in size, has good capacity for controlling anode current, and operates at high frequency.

Accordingly, the present invention provides a "Gate Turn Off" thyristor comprising:

a semiconductor substrate of a first conductivity type having two mutually-opposed major surfaces;

an anode layer of a second conductivity type formed adjacent to one of said surfaces of said semiconductor substrate;

a gate layer of said second conductivity type exposed on the other surface of said semiconductor substrate, and formed in said semiconductor substrate;

a cathode layer of said first conductivity type formed in an integral mesh like arrangment in said gate layer;

an anode electrode connected to said anode

- 4 -
0130669

layer;

a gate electrode respectively connected to island portions of said gate layer selectively exposed through said mesh like arrangment of said cathode layer; and

a cathode electrode connected to said cathode layer.

Some embodiments of the present invention will now be described by way of example with reference to the accompanying drawings, in which:

Fig. 1 is a perspective view, partly in cross-section, of a conventional GTO;

Fig. 2 is a plan view of cathode and gate electrodes in a conventional GTO as shown in Fig. 1;

Figs. 3 and 4 are perspective views, partly in cross-section of a GTO according to the present invention at different stages of the formation of the cathode region;

Figs. 5 and 8 are perspective views of a completed GTO according to the present invention;

Fig. 6 is a schematic plan view of cathode and gate electrodes of a GTO according to the present invention;

Fig. 7 is a cross-sectional view of a GTO according to the present invention;

Figs. 9 and 11 are plan views illustrating different possible island structures of a gate layer of the GTO according to the present invention; and

Fig. 10 is a cross-sectional view taken on lines B-B' and C-C' in Fig. 8.

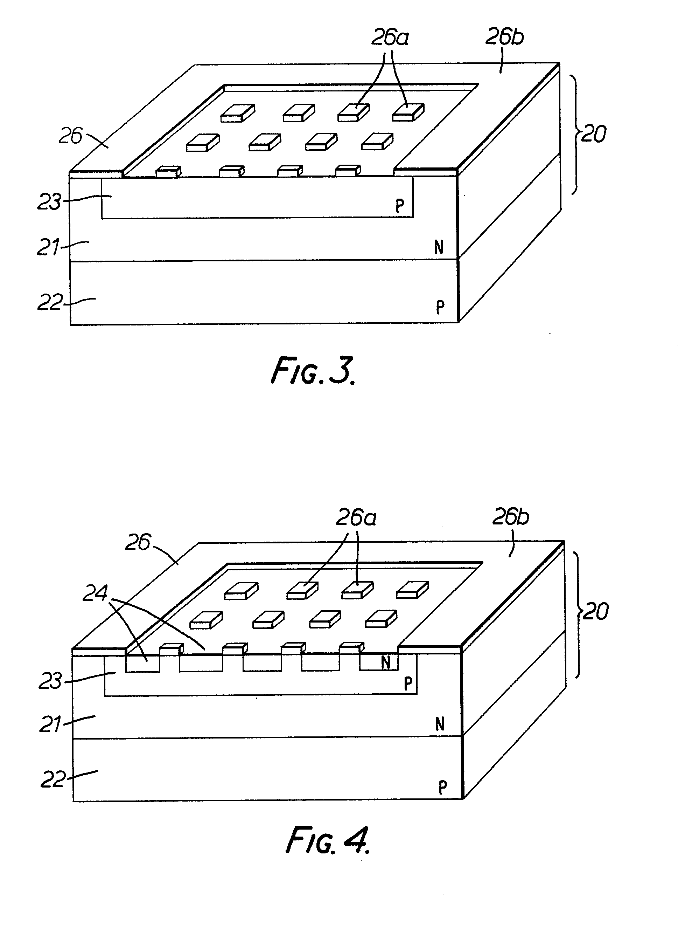

Referring now to Fig. 3, an impurity of a P-conductivity type is diffused into the rear surface of a semiconductor substrate 20 having an N-conductivity type, so as to form an anode layer 22. A gate layer 23 of P-conductivity type is selectively formed in the opposite surface of the semiconductor substrate 20 in a similar manner. The base layer 21, between the anode layer 22 and the gate layer 23 is of N-conductivity type. Next, a silicon dioxide film is formed on the whole surface of semiconductor substrate 20 and selectively removed over the gate layer 23 so as to form a mask 26 to enable a cathode region to be produced using a diffusion technique. The mask 26 is in a mesh pattern with island portions 26a arranged in amatrix at set distances from one another and framed by mask portion 26b.

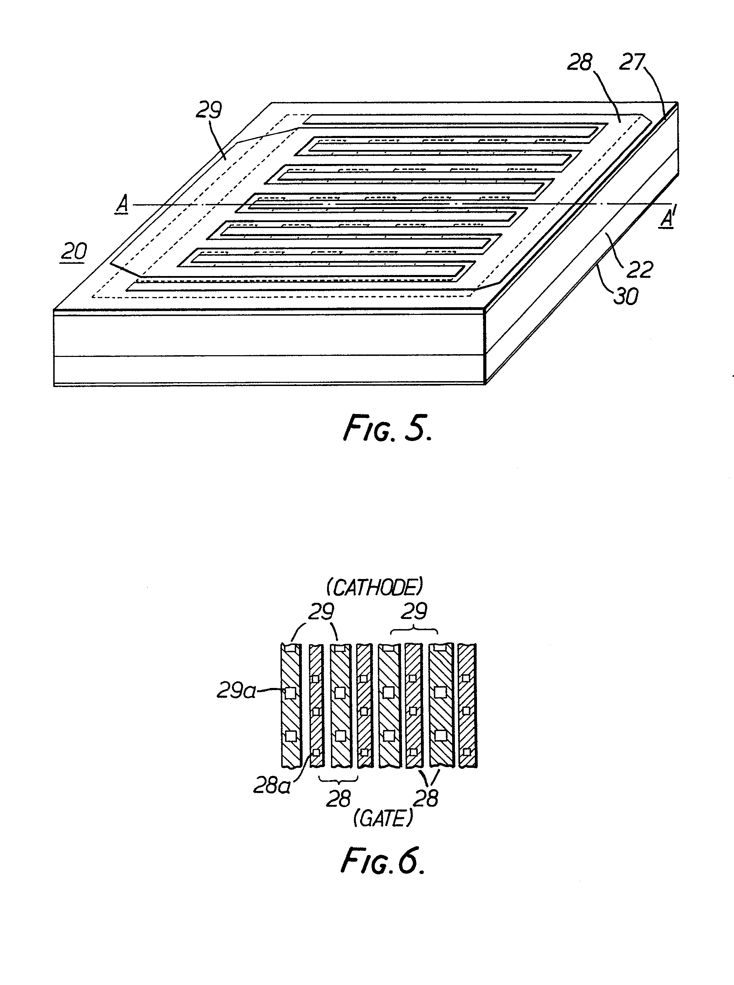

In this way, when an impurity of N-conductivity type is subsequently diffused into the gate layer 23, a mesh-like integral cathode 24 is formed in the gate layer 23 as shown in Fig. 4. The PN junction formed between the base layer 21 and the gate layer 23 is then covered with a passivation film made of, for example, glass, phospho-silicate glass, or polyimide resin (not shown). An insulating film 27 of silicon dioxide having plural contact holes is formed on the surface of the gate layer 23, and a gate electrode 28 for connection to the gate layer 23 and a cathode electrode 29 for connection to the cathode region 24 is formed on the insulating film 27.  An anode electrode 30 is formed on the rear surface of the semiconductor substrate 20 to connect the anode layer 22 as shown in Fig. 5.

Fig. 6 shows the arrangement of the interdigitated gate electrodes 28 and cathode electrodes 29, and of the contact portions 28a to the gate layer 23 and contact portions 29a to the cathode region 24.

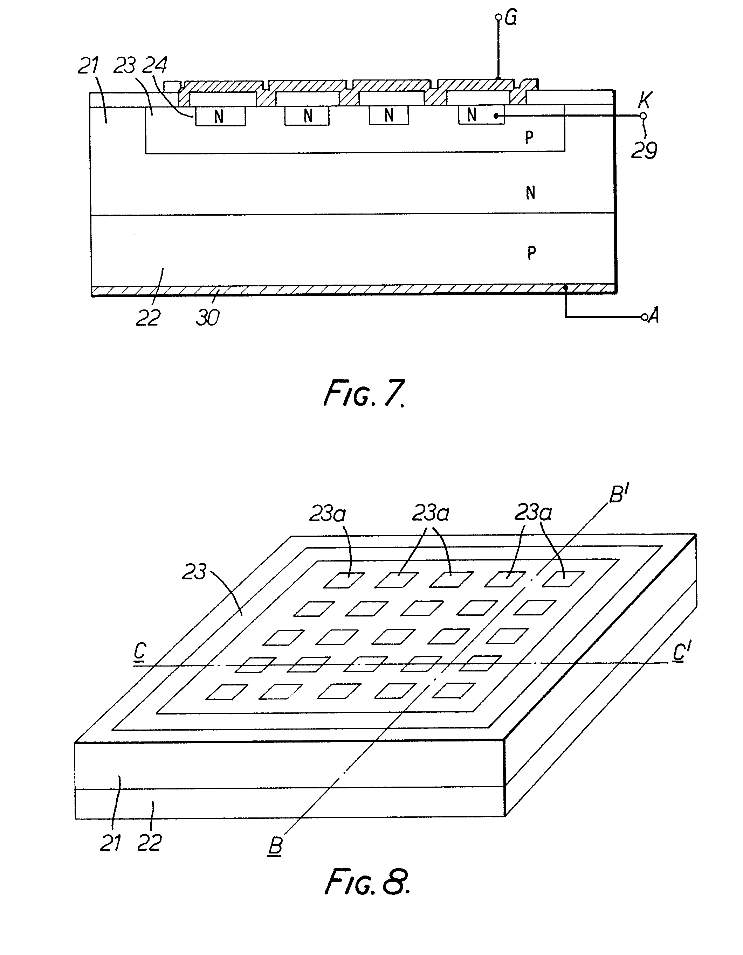

Fig. 7 is a cross-sectional view taken on a line A-A' in Fig. 5.  The gate layer 23 has island portions 23a arranged in a matrix spaced apart by equal distances.  The cathode region 24 is the GTO of the present invention is thus formed as a mesh body compared with the cathode strip regions of the conventional GTO. K, G and A represent the cathode electrode, the gate electrode and the anode electrode respectively.

Fig. 8 shows the GTO before the step of forming the insulating film and the electrodes.

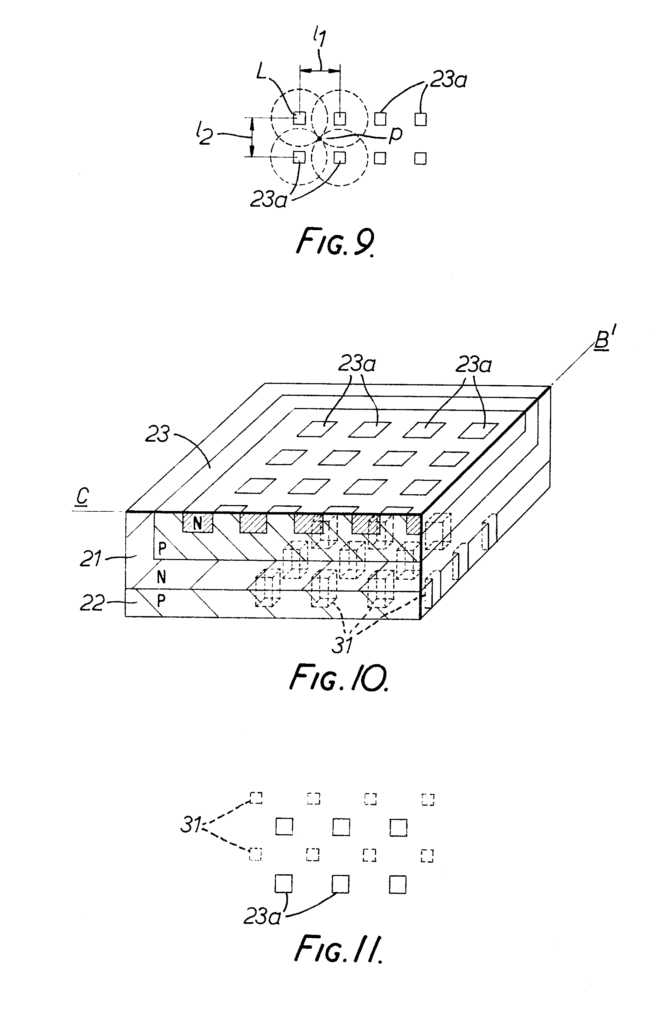

Fig. 9 is a plan view showing the arrangment of the island portions 23a.

The operation of the turn off gate when a signal is applied to the gate layer 23 of the GTO shown in Figs. 8 and 9 will now be explained.  Charge carriers are drawn off through the periphery of the island portions 23a of the gate layer 23.  The charge of the cathode region 24, when the GTO is on, is drawn off by setting the distances $L_1$ and $L_2$ appropriately in relation to the fixed bias of the turn off gate signal.  It is preferable to set up the distance $L_1$ equal to $L_2$ as shown in Fig. 9.  In Fig. 9, four adjacent island portions 23a are treated as one unit region, and the circles shown as dotted lines represent the area for absorbing the charge of the island portions 23a when the turn off gate signal is applied to each island portion 23a of the gate layer 23. Thus the charge carriers in the cathode region 24 are extracted from the center P of the unit regions. When the carrier is extracted at the center P, electric fields affect the carrier from the four island portions 23a. Accordingly, if the distribution of electric intensity of an island portion 23a ia unbalanced by a fault region in the crystal structure, the unbalanced distribution of electric intensity is substantially reduced because the electric fields is reinforced by the other three island portions 23a.

Fig. 10 shows a cross-sectional view taken along lines B-B' and C-C' in Fig. 8. The anode layer 22 has additional intruding regions 31 of N-conductivity type extending through the base layer 21 which are represented by dotted quadrangular columns shown in Fig. 10 showing the arrangement of the island portions 23a and the intruding regions 31. Projected areas of the intruding regions 31 are represented by dotted squares in Fig. 11. Each projected area 31 is located at the center of one group of four adjacent island regions 23a in order to extract the carriers in the base layer 21 quickly when a negative voltage is applied to the gate electrode 8 and a positive voltage is applied to the cathode electrode 29.

In Figs. 10 and 11, the shape of the projected areas 31 are shown as cubic and square respectively, but the shape may be changed, for example, to circular and polygonal.

In the GTO of the present invention, the cathode region 24 as a source of the anode current is formed in a mesh pattern in the gate layer 23, so that the cathode region 24 has a unitary body and so that the area of the cathode region can be large compared with a area of the island portions 23a. Therefore in order to operate at a high frequency if the density of the island portions 23a is increased, the capacity of the controllable current will not be reduced. It is not necessary to make the pellet size larger. The conditions for designing the gate and cathode electrode are eased compared with the conventional GTO. Furthermore, the local current concentration is eased by reducing the imbalance of the electric field intensity.

CLAIMS:

1. A gate turn off thyristor comprising: a semiconductor substrate (20) of a first conductivity type having two mutually opposed major surfaces; an anode layer (22) of a second conductivity type formed at a first one of said surfaces of said semiconductor substrate; a gate layer (23) of said second conductivity type formed in the second surface of said semiconductor substrate; a cathode region (24) of said first conductivity type formed in said gate layer leaving portions of said gate selectively exposed on said second surface; an anode electrode (30) connected to said anode layer; a gate electrode (28) connected to said exposed portions of said gate layer; and a cathode electrode (29) connected to said cathode region; characterised in that said cathode region is formed in a mesh-like pattern in said gate layer so that said selectively exposed gate portions are in the form of discrete islands (23a).

2. A gate turn off thyristor according to claim 1, wherein said island portions of said gate layer are arranged equidistant from one another in each of two orthogonal directions in a matrix pattern.

3. A gate turn off thyristor according to claim 1 or claim 2, further comprising a plurality of intruding regions (31) of the first conductivity type selectively formed in said anode layer (22) and extending through said anode layer towards said substrate (21)

4. A gate turn off thyristor accoring to claim 3, wherein said intruding regions are arranged equidistant from one another in each of two orthogonal directions.

0130669

- 10 -

5. A gate turn off thyristor according to claim 3 wherein the areas of said intruding regions as projected on said second surface are located at the interstices ofthe matrix pattern of said island portions of said gate layer.

6. A gate turn off thyristor according to claim 5, wherein the area of each intruding region, as projected on said second surface, is smaller than the area of the portion of said cathode layer at the interstices of said matrix pattern of said island portions of said gate layer.

7. A gate turn off thyristor according to claim 1, wherein the gate and cathode electrodes are formed in comb like configurations and have interdigitated portions contacting the island portions and the cathode region respectively.

FIG. 1.

FIG. 2.

26a     26b

26

20

23

21

P

22

N

P

FIG. 3.

26a     26b

26

24

23

21

N

P

N

22

P

20

FIG. 4.

FIG. 5.

(CATHODE)

FIG. 6.

0130669

Fig. 7.

Fig. 8.

0130669

FIG.9.

FIG.10.

FIG.11.

# European Patent Office

# EUROPEAN SEARCH REPORT

Application number

EP 84 30 2855

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| A | DE-A-2 825 794 (LICENTIA)<br>* Claim 2; page 9; figures 2A, 2B * | 1,2 | H 01 L 29/08<br>H 01 L 29/743 |
| A | US-A-4 356 503 (SHAFER et al.)<br>* Claim 1; column 3, lines 36-39; figures 1, 4, 5 * | 1,3 | |
| A | FR-A-2 424 631 (FIZIKO -TEKHNICHESKY INSTITUT IMENI A.F. IOFFE AKADEMII NAUK SSSR)<br>* Figures 1, 2 * | | |
| A | DE-A-3 008 034 (NIPPON TELEGRAPH & TELEPHONE)<br>* Claim 1; pages 16, 17, 19; figures 5, 6, 12, 13 * | 1 | |

TECHNICAL FIELDS
SEARCHED (Int. Cl. 3)

H 01 L 29/08
H 01 L 29/74

The present search report has been drawn up for all claims

| Place of search | Date of completion of the search | Examiner |
|---|---|---|
| BERLIN | 19-07-1984 | ROTHER A H J |